# EUROPÄISCHE PATENTSCHRIFT

(11) **EP 1 912 054 B1**
(45) Veröffentlichungstag und Bekanntmachung des Hinweises auf die Patenterteilung: **28.04.2010**
(21) Anmeldenummer: 07017654.0
(22) Anmeldetag: 25.11.1998
(51) Int. Cl.: G01N 13/00, G01N 21/75

(54) **Verfahren zur Untersuchung oder zum Strukturieren einer Oberflächenschicht**
Method for structuring a surface layer
Procédé de structuration d'une couche de surface

(30) Priorität: 04.12.1997 DE 19753790
(43) Veröffentlichungstag der Anmeldung: 16.04.2008
(62) Teilanmeldung aus: 98962395.4
(73) Patentinhaber: Micronas GmbH, 79108 Freiburg i. Br. (DE)
(72) Erfinder: Wolf, Bernhard, 79252 Stegen (DE); Gahle, Hans-Jürgen, 79312 Emmendingen (DE); Igel, Günter, 79331 Teningen (DE); Baumann, Werner Dr. c/o Universität Rostock, 18057 Rostock (DE); Ehret, Ralf, 79291 Merdingen (DE); Lehmann, Mirko, 9642 Ebnat-Kappel (CH)
(74) Vertreter: Göhring, Robert

(56) Entgegenhaltungen:
- DE-A1- 19 512 117
- DE-C1- 19 601 488

## Beschreibung

Die Erfindung bezieht sich auf ein Verfahren zum Strukturieren einer Oberflächenschicht eines Objektes.

Aus der Halbleitertechnik ist bereits ein Verfahren zum Strukturieren einer Oberflächenschicht eines Wafers bekannt, bei dem zunächst eine lichtempfindliche Fotoresist-Emulsion auf die Oberfläche des Wafers aufgebracht wird, die nach Belichtung mit ultraviolettem Licht unlöslich und dadurch gegen eine Chemikalie, beispielsweise eine Säure beständig wird. Die auf den Wafer aufgetragene Emulsion wird dann durch eine fotographische Maske belichtet, wobei die Maske diejenigen Bereiche abdeckt, in denen zur Strukturierung der Oberflächenschicht des Wafers in einem anschließenden Ätzvorgang Wafermaterial abgetragen werden soll. Die so maskierte Emulsion wird dann entwickelt. Anschließend werden die unbelichteten Gebiete mit einem Lösungsmittel entfernt. Als nächster Schritt wird die Waferoberfläche mit einer Säure in Kontakt gebracht, wobei die Fotoresist-Emulsion diejenigen Bereiche schützt, in denen eine Abtragung von Oberflächen material durch Ätzen nicht gewünscht ist. Zum Schluss wird das Fotoresist-Material von der Oberfläche entfernt.

Das vorbekannte Verfahren weist eine Vielzahl von Verfahrensschritten auf und erfordert einen erheblichen apparativen Aufwand. Es ist deshalb vergleichsweise aufwendig und teuer, was besonders in der Serienfertigung von zu strukturierenden Objekten, beispielsweise von Wafern als nachteilig empfunden wird. Darüber hinaus ist der Umgang mit Säuren für das mit der Durchführung des Verfahrens beaufschlagte Personal mit gesundheitlichen Gefahren verbunden und erfordert daher entsprechende Vorsichtsmaßnahmen.

Es besteht deshalb die Aufgabe, ein Verfahren zum Strukturieren einer Oberflächenschicht eines Objekts zu schaffen, das einfach und kostengünstig durchführbar ist.

Die Lösung dieser Aufgabe besteht darin, dass auf die Oberfläche des Objektes in einem Nährmedium und/oder einem osmotischen Schutzmedium Oberflächenmaterial abtragende Biokomponenten aufgebracht werden und dass das Nährmedium und/oder das osmotische Schutzmedium mit den darin enthaltenen Biokomponenten nach dem Abtragen von Oberflächenmaterial von der Objekt-Oberfläche entfernt werden. Die Oberflächenschicht des Objekts kann dadurch auf einfache Weise aufgerauht oder in anderer Weise strukturell verändert werden.

Besonders vorteilhaft ist es, wenn die Biokomponenten adhärent an der Objekt-Oberfläche angelagert werden. An der Oberflächenschicht ergibt sich dann eine der Anordnung der angelagerten Biokomponenten entsprechende Oberflächenstrukturierung.

Eine vorteilhafte Ausführungsform des Verfahrens sieht vor, dass stoffselektive Biokomponenten verwendet werden, die auf das Abtragen eines oder mehrerer, in dem Objekt enthaltener Stoffe spezialisiert sind. Dadurch ist es beispielsweise möglich, an der Oberflächenschicht des Objekts gezielt bestimmte Verunreinigungen zu entfernen und somit das Objekt zu reinigen. Auch kann die chemische Zusammensetzung der Oberflächenschicht durch Abtragen bestimmter Stoffe gezielt verändert werden.

Die vorstehend genannte Aufgabe kann bei einem Verfahren zum Strukturieren einer Oberflächenschicht eines Objekts auch dadurch gelöst werden, dass an der Oberfläche des Objektes in einem Nährmedium und/oder einem osmotischen Schutzmedium ein Ausscheidungsprodukt absondernde Biokomponenten adhärent angelagert werden und dass das Nährmedium und/oder das osmotische Schutzmedium mit den darin enthaltenen Biokomponenten nach dem Absondern des Ausscheidungsprodukts von der Objekt-Oberfläche entfernt werden.

Die Objekt-Oberfläche kann somit auf einfache Weise mit einer Struktur und/oder einer Beschichtung versehen und somit sowohl stofflich als auch strukturell verändert werden. Durch das Nährmedium können die Biokomponenten über einen längeren Zeitraum hinweg vital erhalten werden, so dass sie genügend Zeit zur Verfügung haben, um das Ausscheidungsprodukt abzusondern. Durch das Verfahren ist es insbesondere möglich, die elektrischen Parameter des Objektmaterials zu verändern, was insbesondere in der Halbleitertechnik von Vorteil ist. So kann beispielsweise an der Oberfläche des Objekts eine Zellkultur angelagert werden, die Proteine, Analytika und/oder Pigmente ausscheiden, welche sich an der Objekt-Oberfläche anlagern. Nach dem Entfernen der Zellkultur verbleibt dann an der Oberflächenschicht des Objekts eine durch das Ausscheidungsprodukt der Zellkultur gebildete Strukturierung.

Die vorstehend genannte Aufgabe kann bei einem Verfahren zum Strukturieren einer Oberflächenschicht eines Objekts auch dadurch gelöst werden, dass zur Bildung einer Oberflächenstruktur an der Oberfläche des Objektes in einem Nährmedium und/oder einem osmotischen Schutzmedium Biokomponenten adhärent angelagert werden und dass das Nährmedium und/oder das osmotische Schutzmedium nach dem Anlagern der Biokomponenten von der Objekt-Oberfläche entfernt wird. So können beispielsweise an einem Halbleiter Zellen angelagert werden, die als Dielektrikum dienen. Durch das Nährmedium und/oder das osmotische Schutzmedium können die Biokomponenten über einen längeren Zeitraum hinweg vital erhalten werden, so dass sie genügend Zeit zur Verfügung haben, um sich an der Objektoberfläche anzulagern.

Bei den oben genannten Verfahren zum Strukturieren einer Oberflächenschicht eines Objektes ist es sogar möglich, dass zum Anlagern der Biokomponenten an einem eine bestimmte Struktur aufweisenden Bereich einer Oberflächenschicht oberflächen-strukturselektive Biokomponenten verwendet werden. Bei einem Objekt mit lokal unterschiedlicher Oberflächenstruktur lagern sich dann die Biokomponenten nur an bestimmten Stellen der Oberfläche an. In vorteilhafter Weise ist es dadurch möglich, ohne die Verwendung einer Maske nur bestimmte Bereiche einer Oberflächenschicht zu strukturieren, während die übrigen Bereiche der Oberflächenschicht unverändert belassen werden. So kann beispielsweise bei der Fertigung eines Wafers die Waferoberfläche so ausgebildet werden, dass sich die Biokomponenten nur an bestimmten Stellen des Wafers anlagern, um dort beispielsweise ein Dielektrikum zu bilden und/oder einen Oberflächenbereich des Wafers zu strukturieren.

Die Erfindung bezieht sich auf ein Verfahren zum Strukturieren einer Oberflächenschicht eines Objektes.

Aus der Halbleitertechnik ist bereits ein Verfahren zum Strukturieren einer Oberflächenschicht eines Wafers bekannt, bei dem zunächst eine lichtempfindliche Fotoresist-Emulsion auf die Oberfläche des Wafers aufgebracht wird, die nach Belichtung mit ultraviolettem Licht unlöslich und dadurch gegen eine Chemikalie, beispielsweise eine Säure beständig wird. Die auf den Wafer aufgetragene Emulsion wird dann durch eine fotographische Maske belichtet, wobei die Maske diejenigen Bereiche abdeckt, in denen zur Strukturierung der Oberflächenschicht des Wafers in einem anschließenden Ätzvorgang Wafermaterial abgetragen werden soll. Die so maskierte Emulsion wird dann entwickelt. Anschließend werden die unbelichteten Gebiete mit einem Lösungsmittel entfernt. Als nächster Schritt wird die Waferoberfläche mit einer Säure in Kontakt gebracht, wobei die Fotoresist-Emulsion diejenigen Bereiche schützt, in denen eine Abtragung von Oberflächenmaterial durch Ätzen nicht gewünscht ist. Zum Schluß wird das Fotoresist-Material von der Oberfläche entfernt.

Das vorbekannte Verfahren weist eine Vielzahl von Verfahrensschritten auf und erfordert einen erheblichen apparativen Aufwand. Es ist deshalb vergleichsweise aufwendig und teuer, was besonders in der Serienfertigung von zu strukturierenden Objekten, beispielsweise von Wafern als nachteilig empfunden wird. Darüber hinaus ist der Umgang mit Säuren für das mit der Durchführung des Verfahrens beaufschlagte Personal mit gesundheitlichen Gefahren verbunden und erfordert daher entsprechende Vorsichtsmaßnahmen.

Es besteht deshalb die Aufgabe, ein Verfahren zum Strukturieren einer Oberflächenschicht eines Objekts zu schaffen, das einfach und kostengünstig durchführbar ist.

Die Lösung dieser Aufgabe besteht darin, daß auf die Oberfläche des Objektes in einem Nährmedium und/oder einem osmotischen Schutzmedium Oberflächenmaterial abtragende Biokomponenten aufgebracht werden und daß das Nährmedium und/oder das osmotische Schutzmedium mit den darin enthaltenen Biokomponenten nach dem Abtragen von Oberflächenmaterial von der Objekt-Oberfläche entfernt werden. Die Oberflächenschicht des Objekts kann dadurch auf einfache Weise aufgerauht oder in anderer Weise strukturell verändert werden.

Besonders vorteilhaft ist es, wenn die Biokomponenten adhärent an der Objekt-Oberfläche angelagert werden. An der Oberflächenschicht ergibt sich dann eine der Anordnung der angelagerten Biokomponenten entsprechende Oberflächenstrukturierung.

Eine vorteilhafte Ausführungsform des Verfahrens sieht vor, daß stoffselektive Biokomponenten verwendet werden, die auf das Abtragen eines oder mehrerer, in dem Objekt enthaltener Stoffe spezialisiert sind. Dadurch ist es beispielsweise möglich, an der Oberflächenschicht des Objekts gezielt bestimmte Verunreinigungen zu entfernen und somit das Objekt zu reinigen. Auch kann die chemische Zusammensetzung der Oberflächenschicht durch Abtragen bestimmter Stoffe gezielt verändert werden.

Die vorstehend genannte Aufgabe kann bei einem Verfahren zum Strukturieren einer Oberflächenschicht eines Objekts auch dadurch gelöst werden, daß an der Oberfläche des Objektes in einem Nährmedium und/oder einem osmotischen Schutzmedium ein Ausscheidungsprodukt absondernde Biokomponenten adhärent angelagert werden und daß das Nährmedium und/oder das osmotische Schutzmedium mit den darin enthaltenen Biokomponenten nach dem Absondern des Ausscheidungsprodukts von der Objekt-Oberfläche entfernt werden.

Die Objekt-Oberfläche kann somit auf einfache Weise mit einer Struktur und/oder einer Beschichtung versehen und somit sowohl stofflich als auch strukturell verändert werden. Durch das Nährmedium können die Biokomponenten über einen längeren Zeitraum hinweg vital erhalten werden, so daß sie genügend Zeit zur Verfügung haben, um das Ausscheidungsprodukt abzusondern. Durch das Verfahren ist es insbesondere möglich, die elektrischen Parameter des Objektmaterials zu verändern, was insbesondere in der Halbleitertechnik von Vorteil ist. So kann beispielsweise an der Oberfläche des Objekts eine Zellkultur angelagert werden, die Proteine, Analytika und/oder Pigmente ausscheiden, welche sich an der Objekt-Oberfläche anlagern. Nach dem Entfernen der Zellkultur verbleibt dann an der Oberflächenschicht des Objekts eine durch das Ausscheidungsprodukt der Zellkultur gebildete Strukturierung.

Die vorstehend genannte Aufgabe kann bei einem Verfahren zum Strukturieren einer Oberflächenschicht eines Objekts auch dadurch gelöst werden, daß zur Bildung einer Oberflächenstruktur an der Oberfläche des Objektes in einem Nährmedium und/oder einem osmotischen Schutzmedium Biokomponenten adhärent angelagert werden und daß das Nährmedium und/oder das osmotische Schutzmedium nach dem Anlagern der Biokomponenten von der Objekt-Oberfläche entfernt wird. So können beispielsweise an einem Halbleiter Zellen angelagert werden, die als Dielektrikum dienen. Durch das Nährmedium und/oder das osmotische Schutzmedium können die Biokomponenten über einen längeren Zeitraum hinweg vital erhalten werden, so daß sie genügend Zeit zur Verfügung haben, um sich an der Objektoberfläche anzulagern.

Bei den oben genannten Verfahren zum Strukturieren einer Oberflächenschicht eines Objektes ist es sogar möglich, daß zum Anlagern der Biokomponenten an einem eine bestimmte Struktur aufweisenden Bereich einer Oberflächenschicht oberflächenstrukturselektive Biokomponenten verwendet werden. Bei einem Objekt mit lokal unterschiedlicher Oberflächenstruktur lagern sich dann die Biokomponenten nur an bestimmten Stellen der Oberfläche an. In vorteilhafter Weise ist es dadurch möglich, ohne die Verwendung einer Maske nur bestimmte Bereiche einer Oberflächenschicht zu strukturieren, während die übrigen Bereiche der Oberflächenschicht unverändert belassen werden. So kann beispielsweise bei der Fertigung eines Wafers die Waferoberfläche so ausgebildet werden, daß sich die Biokomponenten nur an bestimmten Stellen des Wafers anlagern, um dort beispielsweise ein Dielektrikum zu bilden und/ oder einen Oberflächenbereich des Wafers zu strukturieren.

## Patentansprüche

1. Verfahren zum Strukturieren einer Oberflächenschicht eines Objektes, **dadurch gekennzeichnet, dass** auf die Oberfläche des Objektes in einem Nährmedium und/oder einem osmotischen Schutzmedium Oberflächenmaterial abtragende Biokomponenten aufgebracht werden und dass das Nährmedium und/oder das osmotische Schutzmedium mit den darin enthaltenen Biokomponenten nach dem Abtragen von Oberflächenmaterial von der Objekt-Oberfläche entfernt werden.

2. Verfahren nach Anspruch 1, **dadurch gekennzeichnet, dass** die Biokomponenten adhärent an der Objekt-Oberfläche angelagert werden:

3. Verfahren nach Anspruch 1 oder 2, **dadurch gekennzeichnet, dass** stoffselektive Biokomponenten verwendet werden, die auf das Abtragen eines oder mehrerer, in dem Objekt enthaltener Stoffe spezialisiert sind.

4. Verfahren nach einem der Ansprüche 1 bis 3, **dadurch gekennzeichnet, dass** das Nährmedium und/oder das osmotische Schutzmedium mit den darin enthaltenen Biokomponenten durch Abspülen von der Objekt-Oberfläche entfernt werden.

5. Verfahren nach einem der Ansprüche 1 bis 4, **dadurch gekennzeichnet, dass** die Biokomponenten und das Nähr- und/oder osmotische Schutzmedium auf die Oberfläche eines aus nicht biologischem Material bestehenden und/oder eine Oberflächenschicht aus einem solchen Material aufweisenden Objekts aufgebracht werden.

6. Verfahren nach einem der Ansprüche 1 bis 5, **dadurch gekennzeichnet, dass** die Biokomponenten und das Nähr- und/oder osmotische Schutzmedium auf die Oberfläche eines Festkörpers aufgebracht werden.

7. Verfahren zum Strukturieren einer Oberflächenschicht eines Objektes, **dadurch gekennzeichnet, dass** an der Oberfläche des Objekts in einem Nährmedium und/oder einem osmotischen Schutzmedium ein Ausscheidungsprodukt absondernde Biokomponenten adhärent angelagert werden und dass das Nährmedium und/oder das osmotische Schutzmedium mit den darin enthaltenen Biokomponenten nach dem Absondern des Ausscheidungsprodukts von der Objekt-Oberfläche entfernt werden.

8. Verfahren zum Strukturieren einer Oberflächenschicht eines Objektes, **dadurch gekennzeichnet, dass** zur Bildung einer Oberflächenstruktur an der Oberfläche des Objekts in einem Nährmedium und/oder einem osmotischen Schutzmedium Biokomponenten adhärent angelagert werden und dass das Nährmedium und/oder das osmotische Schutzmedium nach dem Anlagern der Biokomponenten von der Objekt-Oberfläche entfernt wird.

9. Verfahren nach einem der Ansprüche 1 bis 8, **dadurch gekennzeichnet, dass** zum Anlagern der Biokomponenten an einem eine bestimmte Struktur aufweisenden Bereich einer Oberflächenschicht oberflächenstrukturselektive Biokomponenten verwendet werden.

10. Verfahren nach Anspruch 8 oder 9, **dadurch gekennzeichnet, dass** das Nährmedium und/oder das osmotische Schutzmedium durch Abspülen von der Objekt-Oberfläche entfernt wird.

11. Verfahren nach einem der Ansprüche 7 bis 10, **dadurch gekennzeichnet, dass** die Biokomponenten an der Oberfläche eines aus nicht biologischem Material bestehenden und/oder eine Oberflächenschicht aus einem solchen Material aufweisenden Objekt angelagert werden.

12. Verfahren nach einem der Ansprüche 7 bis 11, **dadurch gekennzeichnet, dass** die Biokomponenten an die Oberfläche eines Festkörpers angelagert werden.

## Claims

1. Method for structuring a surface layer of an object, **characterised in that** biocomponents which remove surface material are applied to the surface of the object in a nutrient medium and/or an osmotic protective medium, and **in that** the nutrient medium and/or the osmotic protective medium together with the biocomponents contained therein are removed from the object surface following the removal of surface material.

2. Method according to claim 1, **characterised in that** the biocomponents are adheringly attached to the object surface.

3. Method according to claim 1 or 2, **characterised in that** use is made of substance-selective biocomponents which are specialised in the removal of one or more substances contained in the object.

4. Method according to one of claims 1 to 3,
**characterised in that** the nutrient medium and/or the osmotic protective medium together with the biocomponents contained therein are removed from the object surface by rinsing.

5. Method according to one of claims 1 to 4,
**characterised in that** the biocomponents and the nutrient medium and/or osmotic protective medium are applied to the surface of an object consisting of non-biological material and/or having a surface layer made from such a material.

6. Method according to one of claims 1 to 5,
**characterised in that** the biocomponents and the nutrient medium and/or osmotic protective medium are applied to the surface of a solid.

7. Method for structuring a surface layer of an object,
**characterised in that** biocomponents which secrete a precipitation product are adheringly attached to the surface of the object in a nutrient medium and/or an osmotic protective medium, and **in that** the nutrient medium and/or the osmotic protective medium together with the biocomponents contained therein are removed from the object surface following the secretion of the precipitation product.

8. Method for structuring a surface layer of an object, **characterised in that**, in order to form a surface structure, biocomponents are adheringly attached to the surface of the object in a nutrient medium and/or an osmotic protective medium, and **in that** the nutrient medium and/or the osmotic protective medium is removed from the object surface following the attachment of the biocomponents.

9. Method according to one of claims 1 to 8,
**characterised in that**, in order to attach the biocomponents to an area of a surface layer having a certain structure, use is made of surface-structure-selective biocomponents.

10. Method according to claim 8 or 9, **characterised in that** the nutrient medium and/or the osmotic protective medium is removed from the object surface by rinsing.

11. Method according to one of claims 7 to 10,
**characterised in that** the biocomponents are attached to the surface of an object consisting of non-biological material and/or having a surface layer made from such a material.

12. Method according to one of claims 7 to 11,
**characterised in that** the biocomponents are attached to the surface of a solid.

## Revendications

1. Procédé pour structurer une couche superficielle d'un objet,
**caractérisé en ce que**
- on applique à la surface de l'objet des biocomposants contenu dans un milieu nutritif et/ou un milieu protecteur osmotique et enlevant la matière de la surface superficielle, et
- on enlève le milieu nutritif et/ou le milieu protecteur osmotique avec les biocomposants qu'il contient après enlèvement de la matière superficielle de la surface de l'objet.

2. Procédé selon la revendication 1,
**caractérisé en ce que**
les biocomposants sont appliqués de façon à adhérer à la surface superficielle de l'objet.

3. Procédé selon la revendication 1 ou 2,
**caractérisé en ce qu'**
on utilise des biocomposants sélectifs vis-à-vis de la matière, et qui sont spécialisés pour enlever une ou plusieurs matières contenues dans l'objet.

4. Procédé selon l'une des revendications 1 à 3,
**caractérisé en ce qu'**
on enlève le milieu nutritif et/ou le milieu protecteur osmotique avec les biocomposants qu'ils contiennent par rinçage de la surface superficielle de l'objet.

5. Procédé selon l'une des revendications 1 à 4,
**caractérisé en ce que**
les biocomposants et le milieu nutritif et/ou le milieu protecteur osmotique, sont appliqués à la surface superficielle d'une matière non-biologique et/ou d'une couche de surface superficielle d'un objet en une telle matière.

6. Procédé selon l'une des revendications 1 à 5,
**caractérisé en ce qu'**
on applique les biocomposants et le milieu nutritif et/ou le milieu protecteur osmotique à la surface superficielle d'un corps solide.

7. Procédé de mise en structure d'une couche de surface superficielle d'un objet,
**caractérisé en ce qu'**
on applique des biocomposants déposant un produit de réaction dans un milieu nutritif et/ou un milieu protecteur osmotique, à la surface superficielle de l'objet de façon à y adhérer, et
on enlève le milieu nutritif et/ou le milieu protecteur osmotique avec les biocomposants qu'il contient après dépôt du produit de réaction de la surface superficielle de l'objet.

8. Procédé de mise en structure d'une couche de surface superficielle d'un objet,
**caractérisé en ce que**
pour former une structure de surface superficielle à la surface de l'objet, on dépose de façon à adhérer des biocomposants contenus dans un milieu nutritif et/ ou un milieu protecteur osmotique, et
on enlève le milieu nutritif et/ou le milieu protecteur osmotique après dépôt des biocomposants à la surface superficielle de l'objet.

9. Procédé selon l'une des revendications 1 à 8,
**caractérisé en ce que**
pour déposer les biocomposants dans une zone présentant une structure déterminée d'une couche superficielle, on utilise des biocomposants sélectifs de structure de surface superficielle.

10. Procédé selon la revendication 8 ou 9,
**caractérisé en ce qu'**
on enlève par rinçage de la surface superficielle de l'objet, le milieu nutritif et/ou le milieu protecteur osmotique.

11. Procédé selon l'une des revendications 7 à 10,
**caractérisé en ce que**
les biocomposants sont appliqués à la surface superficielle d'un matériau non-biologique et/ou à une couche superficielle d'une telle matière d'un objet.

12. Procédé selon l'une des revendications 7 à 11,
**caractérisé en ce qu'**
on dépose les biocomposants à la surface superficielle d'un corps solide.
